# EUROPÄISCHE PATENTSCHRIFT

(11) **EP 0 905 895 B1**
(45) Veröffentlichungstag und Bekanntmachung des Hinweises auf die Patenterteilung: **10.04.2002**
(21) Anmeldenummer: 98112801.0
(22) Anmeldetag: 03.07.1998
(51) Int. Cl.: H03K 5/1252

(54) **Impulsformerschaltung**
Pulse shaping circuit
Circuit de mise en forme d'impulsions

(30) Priorität: 30.09.1997 DE 19743298
(43) Veröffentlichungstag der Anmeldung: 31.03.1999
(73) Patentinhaber: Infineon Technologies AG, 81669 München (DE)
(72) Erfinder: Johnson, Bret, 81737 München (DE); Schneider, Ralf, 81925 München (DE)
(74) Vertreter: Zedlitz, Peter, Dipl.-Inf.

(56) Entgegenhaltungen:
- EP-A- 0 434 380
- EP-A- 0 458 766
- DE-A- 3 239 936
- DE-A- 4 443 954
- US-A- 5 198 710

## Beschreibung

Die Erfindung betrifft eine Impulsformerschaltung.

Ein häufiges Problem bei digitalen Schaltungen stellen sogenannte Störflanken (Glitches) dar, die insbesondere bei den Umschaltflanken eines digitalen Signals auftreten und durch ein Überschwingen in positiver oder negativer Richtung das eigentliche digitale Signal verzerren. Die Ursachen der Störflanken sind vielfältig und demzufolge kann ihre Entstehung nur schwer unterbunden werden. Durch auftretende Störflanken kann jedoch die Funktion digitaler Schaltungen erheblich beeinträchtigt werden.

Aufgabe der Erfindung ist es, eine Schaltung anzugeben, die Störflanken aus einem digitalen Signal eliminiert.

Die Aufgabe wird durch einen Impulsformer gemäß Patentanspruch 1 gelöst. Ausgestaltungen und Weiterbildungen des Erfindungsgedankens sind Gegenstand von Unteransprüchen.

Eine erfindungsgemäße Impulsformerschaltung umfaßt insbesondere einen einen Eingang, einen Ausgang und zwei Versorgungsanschlüsse aufweisenden Buffer, einen zwischen dem einen Versorgungsanschluß und einem erstes Versorgungspotential geschalteten, steuerbaren ersten Schalter, einen zwischen dem anderen Versorgungsspannungsanschluß und einem zweiten Versorgungspotential geschalteten, steuerbaren zweiten Schalter, einen zwischen dem Ausgang des Buffers und dem ersten Versorgungspotential geschalteten, steuerbaren dritten Schalter, sowie einen zwischen dem Ausgang des Inverters und dem zweiten Versorgungspotential geschalteten steuerbaren vierten Schalter. Darüber hinaus ist eine an den Ausgang des Inverters angeschlossene Steuereinrichtung für die Schalter vorgesehen, die bei Auftreten erster Flanken eines am Ausgang des Inverters anliegenden Signals einen ersten Steuerimpuls bestimmter Dauer und bei Auftreten zweiter Flanken einen zweiten Steuerimpuls bestimmter Dauer erzeugt, wobei durch den ersten Steuerimpuls der erste Schalter vom Ein-Zustand in den Aus-Zustand und der vierte Schalter vom Aus-Zustand in den Ein-Zustand umgeschaltet wird und durch den zweiten Steuerimpuls der zweite Schalter vom Ein-Zustand in den Aus-Zustand und der dritte Schalter von Aus-Zustand in den Ein-Zustand umgeschaltet wird.

Bei der erfindungsgemäßen Impulsformerschaltung ist zwischen dem Ausgang und dem Eingang nur ein Buffer geschaltet. Mit den übrigen Schaltungsteilen wird bei jedem Flankenwechsel des Eingangssignals ein Impuls mit einer bestimmten Länge erzeugt. Dieser Impuls blockiert den Buffer und läßt keinen neuen Flankenwechsel am Ausgang des Buffers zu. Erst nach der durch die Impulslänge definierten Totzeit wird der Buffer wieder aktiv und der Zustand des Ausgangs ist wieder vom Eingangszustand abhängig. Diese Totzeitsteuerung erfolgt sowohl für steigende als auch für fallende Flanken des Eingangssignals. Vorteilhaft ist, daß die erfindungsgemäße Impulsformerschaltung direkt in den Signalpfad eingebaut werden kann und nur eine minimale zusätzliche Verzögerung verursacht, da lediglich ein Buffer im Signalpfad liegt.

Bei einer Ausgestaltung der Erfindung werden erster und dritter Schalter durch einen ersten bzw. dritten Transistor vom einem ersten Leitungstyp sowie zweiter und vierter Schalter durch einen zweiten bzw. vierten Transistor von einem zweiten Leitungstyp gebildet, wobei die Steueranschlüsse von erstem und viertem Transistor miteinander verbunden sind und durch den ersten Steuerimpuls gesteuert werden und die Steueranschlüsse von zweitem und drittem Transistor miteinander verbunden sind und durch den zweiten Steuerimpuls gesteuert werden.

Bei einer Weiterbildung der Erfindung umfaßt die Steuerschaltung ein NOR-Gatter, dessen Ausgang mit dem Steueranschluß von erstem und viertem Transistor gekoppelt ist, und ein NAND-Gatter, dessen Ausgang mit den Steueranschlüssen von zweitem und drittem Transistor gekoppelt ist, wobei an jeweils einem Eingang von NOR-Gatter und NAND-Gatter das Ausgangssignal des Buffers und an dem jeweils anderen Eingang das verzögerte, gegenüber dem einen Eingang invertierte Ausgangssignal des Buffers angelegt ist. Vorteilhafterweise ist dabei der für die Realisierung der Steuerschaltung notwendige schaltungstechnische Aufwand sehr gering.

Bevorzugt wird der Buffer durch einen Inverter gebildet, da dieser beste Schalteigenschaften bei geringstem schaltungstechnischen Aufwand garantiert.

Eine bevorzugte Ausführungsform eines Inverters umfaßt einen fünften Transistor vom ersten Leistungstyp und einen sechsten Transistor vom zweiten Leistungstyp, deren miteinander gekoppelte Steueranschlüsse den Eingang des Inverters bilden und deren gesteuerte Strecken in Reihe zueinander zwischen den Versorgungsanschlüssen geschaltet sind, wobei der Abgriff zwischen den beiden gesteuerten Strecken den Ausgang des Inverters bildet.

Die Erfindung wird nachfolgend anhand der in den Figuren der Zeichnung dargestellten Ausführungsbeispiele näher erläutert. Es zeigt:
- Figur 1: ein erstes Ausführungsbeispiel einer erfindungsgemäßen Impulsformerschaltung,
- Figur 2: die Betriebsweise der Schaltung nach Figur 1 in einem Impulsablaufdiagramm,
- Figur 3: ein zweites Ausführungsbeispiel einer erfindungsgemäßen Impulsformerschaltungsanordnung und
- Figur 4: die Arbeitsweise der Schaltung nach Figur 3 in einem Impulsablaufdiagramm.

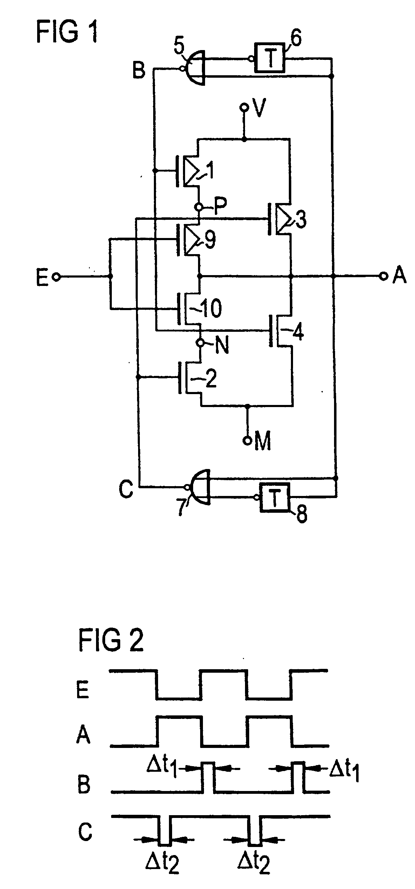

Bei dem Ausführungsbeispiel nach Figur 1 ist ein als steuerbarer Schalter betriebener MOS-Feldeffekttransistor 1 vom p-Kanal-Typ sowie ein ebenfalls als Schalter betriebene MOS-Feldeffekttransistor 2 vom n-Kanal-Typ vorgesehen, die jeweils zwischen einen Versorgungsanschluß P bzw. N einer Bufferschaltung und jeweils einem Versorgungspotential V bzw. M geschaltet sind. Die Bufferschaltung wird durch einen Inverter gebildet, der einen MOS-Feldeffekttransistor 9 vom p-Kanal-Typ und einen MOS-Feldeffekttransistor 10 vom n-Kanal-Typ aufweist. Dabei sind die Drainanschlüsse der beiden Transistoren 9 und 10 einen Ausgang A der Impulsformerschaltung bildend miteinander gekoppelt. Ein Eingang E der Impulsformerschaltung wird durch die miteinander gekoppelten Gateanschlüsse der beiden Transistoren 9 und 10 realisiert.

Schließlich sind die Versorgungsanschlüsse P, N des Inverters durch die Sourceanschlüsse der Transistoren 9 und 10 gegeben, so daß der Sourceanschluß des Transistors 9 über die gesteuerte Strecke des Transistors 1 mit dem Versorgungspotential V und der Sourceanschluß des Transistors 10 über die gesteuerte Strecke des Transistors 2 mit dem Versorgungspotential M verschaltet ist. Im einzelnen sind dazu der Sourceanschluß des Transistors 9 und der Drainanschluß des Transistors 1 und der Sourceanschluß des Transistors 10 und der Drainanschluß des Transistors 2 miteinander verbunden. Folglich ist der Sourceanschluß des Transistors 1 an das Versorgungspotential V und der Sourceanschluß des Transistors 2 jeweils an das Versorgungspotential M angeschlossen.

Des weiteren sind zwischen dem Ausgang A und dem Versorgungspotential V sowie zwischen dem Ausgang A und dem Versorgungspotential M jeweils die gesteuerte Strecke eines MOS-Feldeffekttransistors 3 vom p-Kanal-Typ bzw. eines MOS-Feldeffekttransistors 4 vom n-Kanal-Typ derart geschaltet, daß jeweils die Drainanschlüsse mit dem Ausgang A verbunden sind und die jeweiligen Sourceanschlüsse an das Versorgungspotential V bzw. an das Versorgungspotential M angeschlossen sind. Dabei sind die Gateanschlüsse der Transistoren 1 und 4 miteinander und die Gateanschlüsse der Transistoren 2 und 3 miteinander verschaltet. Die miteinander gekoppelten Gateanschlüsse der Transistoren 1 und 4 werden durch den Ausgang eines NOR-Gatters 5 gesteuert, mit dessen einen Eingang der Ausgang A direkt und mit dessen anderen Eingang der Ausgang A unter Zwischenschaltung eines invertierenden Verzögerungsglieds 6 verbunden ist. Die Gateanschlüsse der Transistoren 2 und 3 sind an den Ausgang eines NAND-Gatters 7 angeschlossen, dessen einer Eingang direkt und dessen anderer Eingang unter Zwischenschaltung eines invertierenden Verzögerungsglieds 8 mit dem Ausgang A verbunden sind.

Die Funktionsweise der Schaltung nach Figur 1 ergibt sich aus Figur 2. Wird am Eingang E ein Rechtecksignal eingespeist, so tritt am Ausgang A ein im wesentlichen demgegenüber invertiertes Signal auf. Am Ausgang B des NOR-Gatters 5 erscheint dabei aufgrund der Verknüpfung des unbearbeiteten Ausgangssignals A und des zeitverzögerten und invertierten Ausgangssignals A jeweils ein Impuls mit der Dauer Δt₁ nach jeder fallenden Flanke des Ausgangssignals A bzw. nach jeder steigenden Flanke des Eingangssignals E. In gleicher Weise werden am Ausgang C des NAND-Gatters 7 Impulse der Länge Δt₂ bei jeder fallenden Flanke des Signals am Eingang E bzw. bei steigender Flanke des Signals am Ausgang A erzeugt. Während das Signal am Ausgang B positive Impulse bietet, stehen am Ausgang C Signale mit negativen Impulsen zur Verfügung. Mit den jeweiligen Impulsen wird mittels der Transistoren 1 und 4 bzw. 2 und 3 der Ausgang A für eine bestimmte Totzeit passiv gesteuert und behaart im jeweils letzten Zustand. Nach Schaltflanken auftretende Glitches werden so ignoriert.

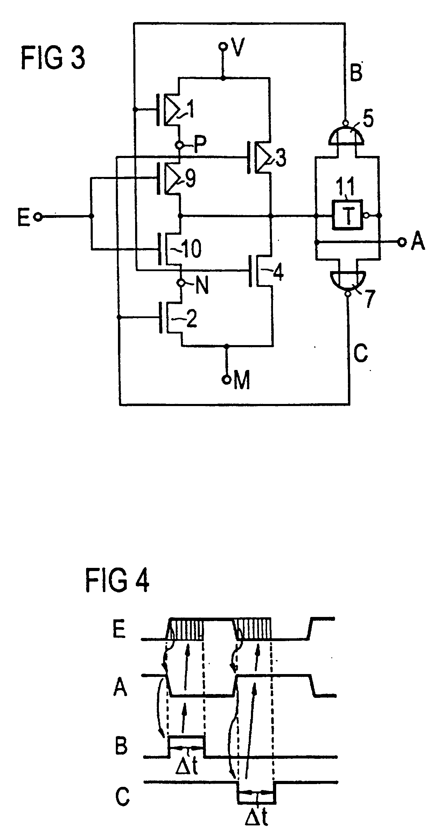

Das Ausführungsbeispiel nach Figur 3 ist gegenüber dem Beispiel aus Figur 1 dahingehend abgeändert, daß anstelle der beiden Verzögerungsglieder 6 und 8 nur ein einziges Verzögerungsglied 11 verwendet wird, wobei die Eingänge des NOR-Gatters 5 und des NAND-Gatters 7 jeweils einander parallel geschaltet sind und jeweils an den Eingang bzw. an den Ausgang des invertierenden Verzögerungsglieds 11 angeschlossen sind.

Die Verhaltensweise der Schaltungsanordnung nach Figur 3 entspricht im wesentlichen der von Figur 1, jedoch wird die Totzeit Δt beim Ausführungsbeispiel nach Figur 3 allein durch das Verzögerungsglied 11 bestimmt und ist daher für beide Gatter im wesentlichen gleich. Gemäß Figur 4 sind wiederum das Signal am Eingang E und das demgegenüber invertierte Signal am Ausgang A gezeigt. Am Ausgang B des NOR-Gatters 5 erscheint dabei ein Impuls der Länge Δt bei jeder fallenden Flanke des Signals am Ausgang A bzw. bei jeder steigenden Flanke des Signals am Eingang E. Entsprechend tritt am Ausgang C des NAND-Gatters 7 ein negativer Impuls der Länge Δt bei jeder steigenden Flanke des Signals am Ausgang A bzw. bei jeder fallenden Flanke des Signals am Eingang E auf. In dem Bereich, in dem einer der Impulse am Ausgang B bzw. C auftritt, werden Änderungen des Signals am Eingang E nicht berücksichtigt.

## Patentansprüche

1. Impulsformerschaltung mit
einem einen Eingang (E), einen Ausgang (A) und zwei Versorgungsanschlüsse aufweisenden Buffer,
einem zwischen einem der Versorgungsanschlüsse (P) und ein erstes Versorgungspotential (V) geschalteten steuerbaren ersten Schalter (1),
einem zwischen dem anderen Versorgungsspannungsanschluß (N) und einem zweites Versorgungspotential (M) geschalteten, steuerbaren zweiten Schalter (2),
einen zwischen den Ausgang des Buffers (9, 10) und das erste Versorgungspotential (V) geschalteten, steuerbaren dritten Schalter (3),
einen zwischen dem Ausgang des Buffers (9, 10) und dem zweiten Versorgungspotential (M) geschalteten, steuerbaren vierten Schalter (4), und
einer an den Ausgang des Buffers (9, 10) angeschlossenen Steuereinrichtung für die Schalter (1, 2, 3, 4), die bei Auftreten erster Flanken eines am Ausgang des Buffers (9, 10) anliegenden Signals einen ersten Steuerimpuls bestimmter Dauer (Δt₁) und bei Auftreten zweiter Flanken einen zweiten Steuerimpuls bestimmter Dauer (Δt₂) erzeugt, wobei durch den ersten Steuerimpuls der erste Schalter (1) vom Ein-Zustand in den Aus-Zustand und der vierte Schalter (4) ' vom Aus-Zustand in den Ein-Zustand umgeschaltet wird und durch den zweiten Steuerimpuls der zweite Schalter (2) vom Ein-Zustand in den Aus-Zustand und der dritte Schalter (3) vom Aus- in den Ein-Zustand umgeschaltet wird.

2. Impulsformerschaltung nach Anspruch 1, bei der der erste und dritte Schalter (1, 3) durch einen ersten und dritten Transistor (1, 3) jeweils von einem ersten Leitungstyp und zweiter und vierter Schalter (2, 4) durch einen zweiten und vierten Transistor (2, 4) von einem zweiten Leitungstyp gebildet werden,
die Steueranschlüsse von erstem und viertem Transistor (1, 4) miteinander verbunden sind und durch den ersten Steuerimpuls (B) gesteuert werden und
die Steueranschlüsse von zweitem und drittem Transistor (2, 3) miteinander verbunden sind und durch den zweiten Steuerimpuls (C) gesteuert werden.

3. Impulsformerschaltung nach Anspruch 1 oder 2; bei der die Steuerschaltung ein NOR-Gatter (5), dessen Ausgang mit den Steueranschlüssen von erstem und viertem Transistor (1, 4) gekoppelt ist, und ein NAND-Gatter (7), dessen Ausgang mit den Steueranschlüssen von zweitem und drittem Transistor (2, 3) gekoppelt ist, aufweist, wobei an jeweils einem Eingang von NOR-Gatter (5) und NAND-Gatter (7) das Ausgangssignal des Buffers (9, 10) und an dem jeweils anderen Eingang das zeitlich verzögerte, invertierte Ausgangssignal des Buffers (9, 10) angelegt ist.

4. Impulsformerschaltung nach einem der vorherigen Ansprüche, bei der der Buffer (9, 10) durch einen Inverter (9, 10) gebildet wird.

5. Impulsformerschaltung nach Anspruch 4, bei der der Inverter (9, 10) einen fünften Transistor (9) vom ersten Leitungstyp und einen sechsten Transistor (10) vom zweiten Leitungstyp aufweist, deren Steueranschlüsse den Eingang des Inverters (9, 10) bildend miteinander gekoppelt sind und deren gesteuerte Strecken in Reihe zueinander zwischen den Versorgungsanschlüssen (P, N) geschaltet sind, wobei der Abgriff zwischen den beiden gesteuerten Strecken den Ausgang des Inverters (9, 10) bilden.

## Claims

1. Pulse shaper circuit containing a buffer having an input (E), an output (A) and two supply connections, containing a controllable first switch (1) connected between one of the supply connections (P) and a first supply potential (V), containing a controllable second switch (2) connected between the other supply voltage connection (N) and a second supply potential (M), containing a controllable third switch (3) connected between the output of the buffer (9, 10) and the first supply potential (V), containing a controllable fourth switch (4) connected between the output of the buffer (9, 10) and the second supply potential (M), and containing a control device for the switches (1, 2, 3, 4) which is connected to the output of the buffer (9, 10), produces a first control pulse of a specific duration (Δt₁) at the occurrence of first edges of a signal which is present at the output of the buffer (9, 10), and produces a second control pulse of a specific duration (Δt₂) at the occurrence of second edges, the first control pulse changing the first switch (1) over from the ON state to the OFF state and the fourth switch (4) over from the OFF state to the ON state, and the second control pulse changing the second switch (2) over from the ON state to the OFF state and the third switch (3) over from the OFF state to the ON state.

2. Pulse shaper circuit according to Claim 1, in which the first and third switches (1, 3) are formed by a first and a third transistor (1, 3) of a first conduction type in each case, and second and fourth switches (2, 4) are formed by a second and a fourth transistor (2, 4) of a second conduction type, the control connections of the first and fourth transistors (1, 4) are connected to one another and are controlled by the first control pulse (B), and the control connections of the second and third transistors (2, 3) are connected to one another and are controlled by the second control pulse (C).

3. Pulse shaper circuit according to Claim 1 or 2, in which the control circuit has a NOR gate (5), whose output is coupled to the control connections of the first and fourth transistors (1, 4), and a NAND gate (7), whose output is coupled to the control connections of the second and third transistors (2, 3), one input of the NOR gate (5) and of the NAND gate (7) in each case being supplied with the output signal from the buffer (9, 10), and the respective other input being supplied with the temporally delayed, inverted output signal from the buffer (9, 10).

4. Pulse shaper circuit according to one of the preceding claims, in which the buffer (9, 10) is formed by an invertor (9, 10).

5. Pulse shaper circuit according to Claim 4, in which the invertor (9, 10) has a fifth transistor (9) of the first conduction type and a sixth transistor (10) of the second conduction type, the control connections of these transistors being coupled to one another so as to form the input of the invertor (9, 10), and the controlled paths of said transistors being connected in series with one another between the supply connections (P, N), the tap between the two controlled paths forming the output of the invertor (9, 10).

## Revendications

1. Circuit de mise en forme d'impulsions comprenant
un tampon comportant une entrée (E), une sortie (A) et deux bornes d'alimentation,
un premier interrupteur commandable (1) branché entre l'une des bornes d'alimentation (P) et un premier potentiel d'alimentation (V),
un deuxième interrupteur commandable (2) branché entre l'autre borne de tension d'alimentation (N) et un deuxième potentiel d'alimentation (M),
un troisième interrupteur commandable (3) branché entre la sortie du tampon (9, 10) et le premier potentiel d'alimentation (V),
un quatrième interrupteur commandable (4) branché entre la sortie du tampon (9, 10) et le deuxième potentiel d'alimentation (M), et
pour les interrupteurs (1, 2, 3, 4), un dispositif de commande qui est raccordé à la sortie du tampon (9, 10) et qui produit, à l'apparition de premiers fronts d'un signal présent à la sortie du tampon (9, 10), une première impulsion de commande d'une durée déterminée (Δt₁) et, à l'apparition de deuxièmes fronts, une deuxième impulsion de commande d'une durée déterminée (Δt₂), la première impulsion de commande commutant le premier interrupteur (1) de l'état connecté à l'état déconnecté et le quatrième interrupteur (4) de l'état déconnecté à l'état connecté et la deuxième impulsion de commande commutant le deuxième interrupteur (2) de l'état connecté à l'état déconnecté et le troisième interrupteur (3) de l'état déconnecté à l'état connecté.

2. Circuit de mise en forme d'impulsions selon la revendication 1, dans lequel le premier et le troisième transistor (1, 3) sont formés respectivement par un premier et un troisième transistor (1, 3) à chaque fois d'un premier type de conductivité et le deuxième et le quatrième transistor (2, 4) sont formés respectivement par un deuxième et un quatrième transistor (2, 4) à chaque fois d'un deuxième type de conductivité, les bornes de commande du premier et du quatrième transistor (1, 4) sont reliées entre elles et sont commandées par la première impulsion de commande (B) et les bornes de commande du deuxième et du troisième transistor (2, 3) sont reliées entre elles et sont commandées par la deuxième impulsion de commande (C).

3. Circuit de mise en forme d'impulsions selon la revendication 1 ou 2, dans lequel le circuit de commande comporte une porte NOR (5) dont la sortie est couplée aux bornes de commande du premier et du quatrième transistor (1, 4) et une porte NAND (7) dont la sortie est couplée aux bornes de commande du deuxième et du troisième transistor (2, 3), à chaque fois une entrée de la porte NOR (5) et de la porte NAND (7) recevant le signal de sortie du tampon (9, 10) et l'autre entrée respective recevant le signal de sortie du tampon (9, 10) inversé et retardé.

4. Circuit de mise en forme d'impulsions selon l'une des revendications précédentes, dans lequel le tampon (9, 10) est formé par un inverseur (9, 10).

5. Circuit de mise en forme d'impulsions selon la revendication 4, dans lequel l'inverseur (9, 10) comporte un cinquième transistor (9) du premier type de conductivité et un sixième transistor (10) du deuxième type de conductivité dont les bornes de commande sont couplées entre elles en formant l'entrée de l'inverseur (9, 10) et dont les sections commandées sont branchées en série l'une de l'autre entre les bornes d'alimentation (P, N), la prise entre les deux sections commandées formant la sortie de l'inverseur (9, 10).
